# EUROPÄISCHE PATENTSCHRIFT

(11) **EP 1 608 089 B1**
(45) Veröffentlichungstag und Bekanntmachung des Hinweises auf die Patenterteilung: **03.09.2008**
(21) Anmeldenummer: 05009815.1
(22) Anmeldetag: 08.04.2002
(51) Int. Cl.: H04B 17/00, G01R 31/28

(54) **Messsystem mit einem Referenzsignal zwischen einem Signalgenerator und einem Signalanalysator**
Measurement system with a reference signal between a signal generator and a signal analyser
Système de mesure avec un signal de référence entre un générateur de signaux et un analyseur de signaux

(30) Priorität: 26.06.2001 DE 10130687
(43) Veröffentlichungstag der Anmeldung: 21.12.2005
(62) Teilanmeldung aus: 02730120.9
(73) Patentinhaber: Rohde & Schwarz GmbH & Co. KG, 81671 München (DE)
(72) Erfinder: Kernchen, Wolfgang, 82054 Sauerlach (DE)
(74) Vertreter: Körfer, Thomas

(56) Entgegenhaltungen:
- WO-A-00/07302
- WO-A-00/79708
- US-A- 5 784 406

## Beschreibung

Die Erfindung betrifft ein Meßsystem mit einem Signalgenerator, der ein digital moduliertes Hochfrequenz-Meßsignal durch Modulation mit Modulationsdaten erzeugt, das dem Eingang eines Prüflings zugeführt wird, und einem Signalanalysator, der mit dem Ausgang des Prüflings verbunden ist und das Ausgangssignal des Prüflings nach dessen Demodulation analysiert.

Solche Meßsysteme werden beispielsweise bei der Entwicklung und Produktion von Komponenten der Mobilfunktechnik eingesetzt. Die Signalanalysatoren sind beispielsweise Spektrumanalysatoren, Vektorsignalanalysatoren, Time-Domain-Analysatoren, Code-Domain-Analysatoren oder Systemprotokolltester. Mit diesen werden neben den allgemeinen Messungen etwa des Pegels, des Spektrums usw. auch Messungen durchgeführt, bei welchen das empfangene Signal vor der Analyse demoduliert werden muß. Die Signalgeneratoren erzeugen Hochfrequenz-Meßsignale entsprechend dem Übertragungsstandard, beispielsweise dem GSM (Global System for Mobile Communication)-Standard oder einem Weitband-CDMA (Code Division Multiple Access)-Standard für die dritte Generation Mobilfunk UMTS (Universal Mobile Telecommunication Standard). Zur Messung der Bitfehlerrate bzw. des EVM (Error Vector Magnitude, Fehlervektorgröße) oder des Phasen- oder Frequenz-Versatzfehlers ist es erforderlich, die durch die Demodulation des Ausgangssignals des Prüflings ermittelte Ist-Symbolfolge bzw. Ist-Bitfolge mit der Soll-Symbolfolge bzw. der Soll-Bitfolge, mit welcher das dem Prüfling zugeführte Meßsignal in dem Signalgenerator moduliert wurde, zu vergleichen.

In Betriebsgeräten (Mobilstationen, Basisstationen, etc.) werden die Nutzdaten vor der Modulation in dem Sender mit Fehlerschutzdaten versehen, die dem Empfänger in begrenztem Maße eine Fehlerkorrektur ermöglichen, d. h. die fehlerhaft empfangenen Bits bzw. Symbole können in begrenztem Maße korrigiert werden.

Diese Vorgehensweise wäre grundsätzlich auch bei Signalanalysatoren möglich. Nachteilig wäre jedoch daß die Signalanalysatoren eine große Vielfalt von Betriebsstandards beispielsweise sowohl für die zweite Generation als auch dritte Generation Mobilfunk beherrschen müssen und es aus Aufwandsgründen nicht möglich ist, die sehr unterschiedlichen Fehlerkorrekturverfahren sämtlicher Betriebsstandards in einem universellen Signalanalysator zu implementieren. In universell einsetzbaren Signalanalysatoren können deshalb nur universelle Demodulatoren eingesetzt werden, die die Fehlerschutzmechanismen nicht auswerten können. Somit können jedoch bei universellen Signalanalysatoren die Fehlerschutzmethoden nicht zur Generierung der Soll-Symbolfolge bzw. Soll-Bitfolge benutzt werden, d. h. das Signal kann nicht in allen Betriebsfällen analysiert werden.

Selbst wenn in den Signalanalysatoren mit dem dafür notwendigen erheblichen Aufwand Demodulatoren eingesetzt würden, die die unterschiedlichen Fehlerschutzmethoden für sämtliche in der Praxis vorkommenden Betriebsstandards beherrschten, besteht ein weiteres Problem darin, daß auch Messungen durchgeführt werden müssen, bei welchen der Prüfling mit einem im normalen Betriebsfall nicht vorkommenden gestörten Signal beaufschlagt wird, um den Prüfling in Grenzsituationen zum Testen des Übergangsverhaltens zu testen. Beispielsweise sind in dem Signalgeneratoren Rauscheinheiten und Verzerrungseinheiten vorhanden, die das Meßsignal mit einem Rauschen und einer Verzerrung beaufschlagen können, das bzw. die größer als der im Betriebsfall vorkommende Rauschanteil oder die im Betriebsfall vorkommende Verzerrung ist. Somit ist im Meßfall die Energie pro Bit E_{b} im Verhältnis zu der Rauschleistung N₀ kleiner, so daß die Fehlerkorrekturverfahren keine vollständige Korrektur der Bit- bzw. Symbol fehler mehr zulassen und die Soll-Bitfolge bzw. Soll-Symbolfolge auch durch Ausnutzung der Fehlerkorrekturverfahren nicht vollständig wiederhergestellt werden kann.

Ein weiteres Problem beim Stand der Technik besteht darin, daß auf verschiedene Teilsignalabschnitte des Meßsignals synchronisiert werden muß. Beispielsweise muß bei einem GSM-Signal, dessen TDMA-Frame (Time Division Multiple Access-Rahmen) sich in acht Time-Slots (Zeitschlitze) gliedert, auf eine in der Mitte jedes Slots vorhandene Trainingssequenz als Synchronbitfolge synchronisiert werden. Um sich auf diese Trainingssequenzen synchronisieren zu können, müssen dem Signalanalysator die Synchronbitfolgen, die der Signalgenerator erzeugt, bekannt sein. Bislang war dies nur möglich, indem die Synchronbitfolgen über eine Tastatur in den Signalanalysator händisch eingegeben wurden. Dies ist umständlich, führt zu Eingabefehlern und bei einem häufigen Wechsel der Synchronbitfolge zu einer längeren Meßzeit.

Aus der US 5,784,406 A ist eine Vorrichtung zur Auslegung eines Kommunikationssystems bekannt, wobei die Vorrichtung eine Serie von Tests durchführt, welche die Verzögerungszeit, den Frequenzgang, das Hintergrundrauschen, die Rahmenfehlerrate, die Abtastunschärfe und die Wiederholrate bestimmen. Dabei generiert ein Signalgenerator eine Signalserie, die passend zu einem speziellen Test ausgewählt wurde und die mittels des Kommunikationssystems übertragen wird und mittels einer fern platzierten Rückführeinheit zurückgesendet wird. Das rückgeführte Signal wird dann von Überwachungselementen analysiert. Ferner umfasst die in der US 5,784,406 A beschriebene Vorrichtung eine Echo-Kompensation, welche das Echo des zu analysierenden Signals unterdrückt. Referenzsignal und zu analysierendes Signal jedoch können unterschiedliche Laufzeiten aufweisen, welche nicht kompensiert werden.

Der Erfindung liegt deshalb die Aufgabe zugrunde, ein Meßsystem zu schaffen, das mit vertretbarem Aufwand für unterschiedlichste Betriebsstandards und bei einem hohen Signal/Rausch-Verhältnis einsetzbar ist.

Die Aufgabe wird durch die Merkmale des Anspruchs 1 gelöst.

Erfindungsgemäß ist zwischen dem Signalgenerator und dem Signalanalysator eine direkte Verbindung vorgesehen, über welche ein Referenzsignal des Signalgenerators dem Signalanalysator direkt zugeführt wird. Über diese Verbindung können Signale oder Daten übertragen werden, die in dem Signalanalysator eine einfache Rekonstruktion der Soll-Bitfolge bzw. Soll-Symbolfolge ermöglicht, ohne daß hierzu eine Rekonstruktion aus dem Meßsignal unter Verwendung von Fehlerkorrekturverfahren notwendig ist.

Die Unteransprüche betreffen vorteilhafte Weiterbildungen der Erfindung.

Bei dem Referenzsignal kann es sich um die Modulationsdaten, daß I/Q-Ausgangssignal des I/Q-Modulators oder beispielsweise um die Folge der Frequenzwerte eines FSK-Verfahrens handeln.

Vorteilhaft kann über die erfindungsgemäße direkte Verbindung zwischen dem Signalgenerator und dem Signalanalysator auch eine Synchronbitfolge zur Synchronisation auf Teilsignale des Meßsignals übertragen werden.

Um einen möglichen Zeitversatz zwischen dem Demodulationssignal des Prüflings und dem Referenzsignal zu bestimmen, kann in dem Signalanalysator ein entsprechender Korrelator vorgesehen sein. Ferner ist eine Zeitverschiebungseinrichtung vorgesehen , die den Zeitversatz korrigiert.

Ein Ausführungsbeispiel der Erfindung wird nachfolgend unter Bezugnahme auf die Zeichnung näher beschrieben. In der Zeichnung zeigen:
- Fig. 1: ein Blockschaltbild eines Ausführungsbeispiels des erfindungsgemäßen Meßsystems;
- Fig. 2: ein Blockschaltbild eines bei dem Ausführungsbeispiel des erfindungsgemäßen Meßsystems verwendeten Signalgenerators;
- Fig. 3: ein Blockschaltbild eines bei dem Ausführungsbeispiel des erfindungsgemäßen Meßsystems verwendeten Signalanalysators und
- Fig. 4: ein Zeitschema zur Erläuterung eines GSM-Signals.

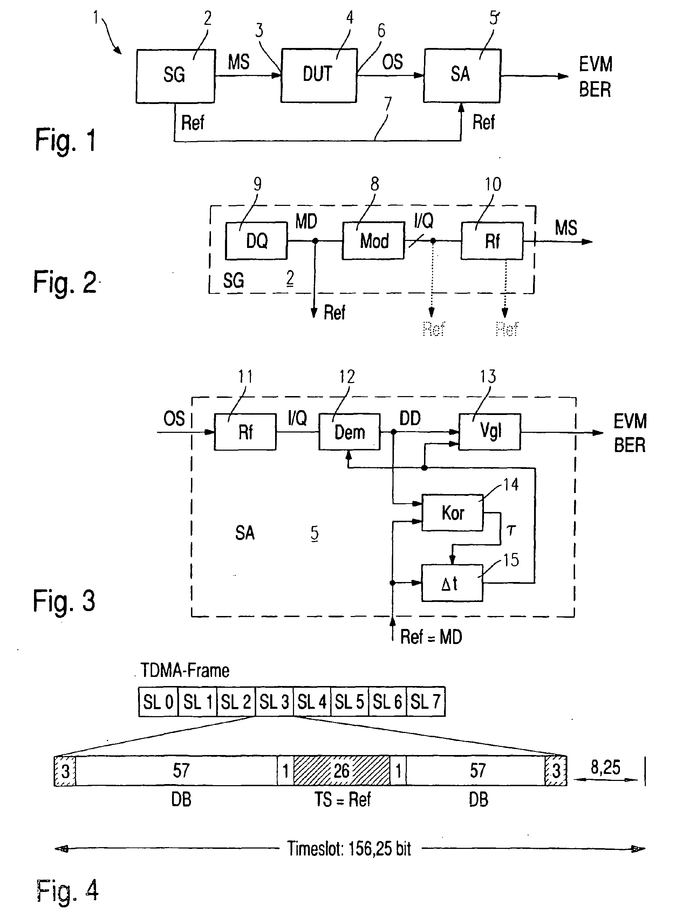

Fig. 1 zeigt ein Blockschaltbild des erfindungsgemäßen Meßsystems 1. Ein Signalgenerator 2 erzeugt ein digital moduliertes Hochfrequenz-Meßsignal MS, beispielsweise ein Mobilfunksignal nach dem GSM-Standard oder einem W-CDMA-Standard. Das Meßsignal MS wird in Hochfrequenzlage einem Eingang 3 eines Prüflings (DUT Device Under Test) 4 zugeführt. Bei dem Prüfling 4 handelt es sich beispielsweise um eine Komponente der Mobilfunktechnik, beispielsweise einen Verstärker einer Basisstation. Ein Signalanalysator 5 steht mit dem Ausgang 6 des Prüflings 4 in Verbindung und empfängt dessen Ausgangssignal OS. Der Signalanalysator 5, beispielsweise ein Spektrumanalysator oder ein Vektoranalysator, transformiert das Hochfrequenz-Ausgangssignal OS in das Basisband, führt eine Demodulation durch und analysiert das demodulierte Signal, um beispielsweise die Bitfehlerrate (BER Bit Error Rate) oder die Fehlervektorgröße (EVM Error Vector Magnitude) eines Phasen- oder Frequenzablagefehlers zu ermitteln.

Erfindungsgemäß ist zwischen dem Signalgenerator 2 und dem Signalanalysator 5 eine direkte Verbindung 7 vorgesehen. Die direkte Verbindung 7 kann entweder kabelgebunden oder auch drahtlos, beispielsweise über Sender und Empfänger die nach dem Blue-Tooth-Prinzip arbeiten, ausgebildet sein. Über die direkte Verbindung wird dem Signalanalysator 5 von dem Signalgenerator 2 ein Referenzsignal Ref zugeführt.

Fig. 2 zeigt ein stark vereinfachtes Blockdiagramm des Signalgenerators 2, wobei nur die für die Erfindung relevanten Komponenten dargestellt sind. Von einer Datenquelle 6 werden beispielsweise pseudozufällige Modulationsdaten MD erzeugt. Die Modulationsdaten MD können dem Signalgenerator 2 jedoch auch über eine externe Schnittstelle zugeführt werden. Bei den Modulationsdaten MD handelt es sich um eine Folge von Datenbits oder Datensymbolen oder auch um eine Folge von Chips eines W-CDMA-Signals, die aus den Datenbits nach Multiplikation mit einer Spreizsequenz entstehen. Diese Modulationsdaten MD werden einem Modulator, bevorzugt einem I/Q-Modulator 8 zugeführt. Am Ausgang des I/Q-Modulators 8 steht das I(Inphase)-Signal und das Q(Quadraturphase)-Signal zur Verfügung, das einer Hochfrequenzeinheit 10 zugeführt wird. Die Hochfrequenzeinheit 10 bringt das Signal vom Basisband zunächst in eine Zwischenfrequenzlage und dann in die Hochfrequenzlage, in welcher der Prüfling 7 arbeitet.

Bei einen bevorzugten Ausführungsbeispiel werden als Referenzsignal Ref die Modulationsdaten MD verwendet. Es ist jedoch auch denkbar, als Referenzsignal Ref die I/Q-Ausgangssignale des I/Q-Modulators 9 zu verwenden, was in Fig. 2 gestrichelt angedeutet ist. Weiterhin ist es auch denkbar, als Referenzsignal Ref ein Zwischenfrequenzsignal der Hochfrequenzeinheit 10 zu verwenden, was in Fig. 2 ebenfalls gestrichelt angedeutet ist.

Fig. 3 zeigt ein stark vereinfachtes, auf die erfindungsgemäßen Komponenten beschränktes Blockschaltbild des Signalanalysators 5. Bei diesem Ausführungsbeispiel wird davon ausgegangen, daß es sich bei dem von dem Signalgenerator 2 zugeführten Referenzsignal Ref um dessen Modulationsdaten MD handelt. Der Signalanalysator 5 hat eine Hochfrequenzeinheit 11, die das Ausgangssignal OS des Prüflings 4 von der Hochfrequenzlage in das Basisband transformiert und einem Demodulator, vorzugsweise einem I/Q-Demodulator 12, zuführt. Am Ausgang des Demodulators 12 stehen die Demodulationsdaten DD zur Verfügung; hierbei handelt es sich um die Ist-Symbolfolge bzw. Ist-Bitfolge des von dem Prüfling 4 empfangenen Ausgangssignals OS. Zur Bewertung der Bitfehlerrate BER oder zum Bestimmen einer anderen Fehlergröße, beispielsweise des EVM (Error Vector Magnitude) ist eine Vergleichseinrichtung 13 vorgesehen, die die durch die Demodulationsdaten DD repräsentierte Ist-Bitfolge bzw. Ist-Symbolfolge mit einer Soll-Bitfolge bzw. Soll-Symbolfolge vergleicht. Diese Soll-Bitfolge bzw. Soll-Symbolfolge wird durch das dem Signalanalysator 5 direkt von dem Signalgenerator 2 über die Verbindung 7 zugeführte Referenzsignal Ref erzeugt.

Werden die Modulationsdaten MD so über die Verbindung 7 übertragen, daß sie synchron zu den entsprechenden Demodulationsdaten DD an der Vergleichseinheit 13 eintreffen, so kann das Referenzsignal Ref direkt der Vergleichseinheit 13 zugeführt werden. Im allgemeinen sind jedoch Laufzeitunterschiede zwischen dem Signalpfad über den Prüfling 7 einerseits und die direkte Verbindung 7 andererseits vorhanden. Der sich durch die Laufzeitunterschiede ergebende Zeitversatz τ kann durch einen Korrelator 14 ermittelt werden, dessen Eingängen die Demodulationsdaten DD einerseits und das Referenzsignal Ref andererseits zugeführt werden. In einer Zeitverschiebungseinrichtung 15, beispielsweise einem Pufferspeicher, kann das Referenzsignal Ref um eine Zeitverschiebung Δ*t* verschoben werden, welche dem von dem Korrelator 14 bestimmten Zeitversatz τ entspricht. Es ist vorteilhaft, die Modulationsdaten MD über die Verbindung 7 so zu übertragen, daß die Modulationsdaten MD an dem Signalanalysator 5 eintreffen, bevor die entsprechenden Demodulationsdaten DD von dem Demodulator 12 demoduliert sind. Der Ausgang der Zeitverschiebungseinrichtung 15 wird einem Eingang der Vergleichseinrichtung 13 zugeführt.

Die Vergleichseinrichtung 13 vergleicht die durch die Modulationsdaten gegebene Soll-Bitfolge bzw. Soll-Symbolfolge mit der durch die Demodulationsdaten DD gegebene Ist-Bitfolge bzw. Ist-Symbolfolge und kann somit fehlerhafte Bits bzw. fehlerhafte Symbole feststellen und beispielsweise als Bitfehlerrate BER oder als EVM (Error Vector Magnitude) auswerten. Aufgrund der Tatsache, daß über die Verbindung 7 stets ein fehlerfreies Referenzsignal Ref zur Verfügung steht, kann die Messung auch bei stark gestörten Signalen durchgeführt werden und eine Auswertung des Fehlerkorrekturcodes (z. B. mit Hilfe eines aufwendigen Viterbi-Decoders) ist nicht erforderlich.

Das Referenzsignal Ref kann optional mit Zusatzsignalen, die bestimmte Zeitpunkte in dem Datenstrom markieren, beispielsweise die Position eines Rahmens (Frame) eines Zeitschlitzes (Time Slot) eines Bursts oder den Beginn einer Synchronisationssequenz, erweitert werden. Die von dem Signalgenerator 2 aktuell verwendete Synchronisationssequenz kann außerdem über das Referenzsignal Ref direkt dem Signalanalysator 5 übermittelt werden. Das bisher übliche, umständlich manuelle Eingeben der Synchronisationssequenz in den Signalanalysator 5 entfällt. Der Signalanalysator 5 ist somit in der Lage auch eine große Anzahl von Synchronisationssequenzen mit dem Demodulationsdaten DD zu vergleichen, da der Signalanalysator 5 stets darüber informiert ist, welche Synchronisationssequenz der Signalgenerator 2 aktuell verwendet. Somit wird die Analyse schneller und/oder der Aufwand in dem Signalanalysator 5 wird erniedrigt. Die parallele Beobachtung aller möglichen Trainingssequenzen TS entfällt.

Der Vorteil der Übermittlung der Synchronisationssequenz über die Verbindung 7 wird an dem Beispiel eines GSM-Signals nachfolgend anhand von Fig. 4 erläutert. Fig. 4 zeigt einen TDMA(Time Division Multiple Access)-Rahmen (Frame). Ein TDMA-Rahmen gliedert sich in acht Timeslots (Zeitschlitze) SL0, SL1, SL2, SL3, SL4, SL5, SL6 und SL7. Wie im unteren Teilbild von Fig. 4 dargestellt, befindet sich in der Mitte eines jeden Timeslots zwischen den Datenbits DB jeweils eine Trainingssequenz TS mit 26 Bits. Beim Aufsynchronisieren auf eine bestimmte Stelle der Demodulationsdaten DD kann diese Trainingssequenz TS verwendet werden. Die Anzahl der insgesamt möglichen Trainingssequenzen TS ist relativ groß. Ist dem Signalanalysator 5 nicht bekannt, welche Trainingssequenz TS der Signalgenerator 2 für einen bestimmten Timeslot verwendet, so muß der Signalanalysator 5 die Demodulationsdaten DD gegen alle möglichen Trainingssequenzen TS vergleichen. Erhält der Signalanalysator 5 von dem Signalgenerator 2 über die Verbindung 7 jedoch eine Information über die für einen bestimmten Timeslot aktuelle verwendete Trainingssequenz TS, so ist nur ein Vergleich gegen eine einzige Trainingssequenz TS notwendig. Ändert der Signalgenerator 2 die Trainingssequenz TS, so erfährt dies der Signalanlysator 5 über das Referenzsignal Ref.

Als Referenzsignal Ref kann bei einem FSK(Frequency Shift Keying)-System auch die Folge der Frequenzwerte, die von dem FSK-Modulator angesprungen werden, übertragen werden.

## Patentansprüche

1. Meßsystem (1) mit einem Signalgenerator (2), der ein digital moduliertes Hochfrequenz-Meßsignal (MS) durch Modulation mit Modulationsdaten (MD) erzeugt, das dem Eingang (3) eines Prüflings (4) zugeführt wird, und einem Signalanalysator (5), der mit dem Ausgang (6) des Prüflings (4) verbunden ist und das Ausgangssignal (OS) des Prüflings (4) nach dessen Demodulation analysiert, wobei zwischen dem Signalgenerator (2) und dem Signalanalysator (5) eine direkte Verbindung (7) besteht, über welche ein Referenzsignal (Ref) des Signalgenerators (2) dem Signalanalysator (5) direkt zugeführt wird und wobei der Signalanalysator (5) eine Vergleichseinrichtung (13) aufweist, in welcher das demodulierte Ausgangssignal (DD) des Prüflings (4) zur Ermittlung einer Fehlerrate (BER) mit dem Referenzsignal (Ref) verglichen wird,
**dadurch gekennzeichnet,**
**dass** der Signalanalysator (5) eine Zeitverschiebungseinrichtung (15) aufweist, welche das Referenzsignal (Ref) oder das demodulierte Ausgangssignal (DD) des Prüflings (4) um eine Zeitverschiebung (Δt) verschiebt, die dem Zeitversatz (τ) zwischen dem demodulierten Ausgangssignal (DD) des Prüflings (4) und dem Referenzsignal (Ref) entspricht.

2. Meßsystem nach Anspruch 1,
**dadurch gekennzeichnet,**
**dass** es sich bei dem Referenzsignal (Ref) um die Modulationsdaten (MD) handelt, mit welchen der Signalgenerator (2) das Hochfrequenz-Meßsignal (MS) moduliert.

3. Meßsystem nach Anspruch 1,
**dadurch gekennzeichnet,**
**dass** der Signalgenerator (2) einen I/Q-Modulator (8) aufweist und dass es sich bei dem Referenzsignal (Ref) um die I/Q-Ausgangssignale (I/Q) des I/Q-Modulators (8) handelt.

4. Meßsystem nach Anspruch 1,
**dadurch gekennzeichnet,**
**dass** der Signalgenerator (2) einen Frequenzsprung (FSK)-Modulator aufweist und dass es sich bei dem Referenzsignal (Ref) um die Folge der Frequenzwerte handelt, die von dem Frequenzsprung (FSK)-Modulator angesprungen werden.

5. Meßsystem nach Anspruch 1,
**dadurch gekennzeichnet,**
**dass** das Referenzsignal (Ref) eine Synchronisationssequenz (TS) beinhaltet, mit der ein Signalabschnitt (SLO-SL7) des von dem Signalgenerator (2) erzeugten Hochfrequenz-Meßsignals (MS) identifizierbar ist.

6. Meßsystem nach Anspruch 1,
**dadurch gekennzeichnet,**
**dass** der Signalanalysator (5) einen Korrelator (14) aufweist, der das demodulierte Ausgangssignal (DD) des Prüflings (4) mit dem Referenzsignal (Ref) korreliert, um den Zeitversatz (τ) zwischen dem demodulierte Ausgangssignal (DD) des Prüflings (4) und dem Referenzsignal (Ref) zu bestimmen.

## Claims

1. Measuring system (1) having a signal generator (2), which generates a digitally modulated high frequency measuring signal (MS) by modulation with modulation data (MD), which signal is supplied to the input (3) of a test unit (4), and having a signal analyser (5), which is connected to the output (6) of the test unit (4) and analyses the output signal (OS) of the test unit (4) after demodulation thereof, a direct connection (7) existing between the signal generator (2) and the signal analyser (5), via which connection a reference signal (Ref) of the signal generator (2) is supplied directly to the signal analyser (5), and the signal analyser (5) having a comparator device (13) in which the demodulated output signal (DD) of the test unit (4) is compared with the reference signal (Ref) in order to determine an error rate (BER),
**characterised in that**
the signal analyser (5) has a time shift device (15) which shifts the reference signal (Ref) or the demodulated output signal (DD) of the test unit (4) by a time shift (Δt) which corresponds to the time delay (τ) between the demodulated output signal (DD) of the test unit (4) and the reference signal (Ref).

2. Measuring system according to claim 1,
**characterised in that**
the reference signal (Ref) concerns the modulation data (MD) with which the signal generator (2) modulates the high frequency measuring signal (MS).

3. Measuring system according to claim 1,
**characterised in that**
the signal generator (2) has an I/Q modulator (8) and **in that** the reference signal (Ref) concerns the I/Q output signals (I/Q) of the I/Q modulator (8).

4. Measuring system according to claim 1,
**characterised in that**
the signal generator (2) has a frequency hopping (FSK) modulator and **in that** the reference signal (Ref) concerns the sequence of the frequency values which are caused to hop by the frequency hopping (FSK) modulator.

5. Measuring system according to claim 1,
**characterised in that**
the reference signal (Ref) includes a synchronisation sequence (TS) with which a signal portion (SLO-SL7) of the high frequency measuring signal (MS) generated by the signal generator (2) is identifiable.

6. Measuring system according to claim 1,
**characterised in that**
the signal analyser (5) has a correlator (14) which correlates the demodulated output signal (DD) of the test unit (4) with the reference signal (Ref) in order to determine the time delay (τ) between the demodulated output signal (DD) of the test unit (4) and the reference signal (Ref).

## Revendications

1. Système de mesure (1) avec un générateur de signaux (2) qui génère par la modulation avec des données de modulation (MD) un signal numérique modulé de mesure (MS) à haute fréquence qui est amené à l'entrée (3) d'un dispositif sous test (4), et avec un analyseur de signaux (5) qui est relié à la sortie (6) du dispositif sous tests (4) et analyse le signal de sortie (OS) du dispositif sous test (4) après sa démodulation, une connexion directe (7) existant entre le générateur de signaux (2) et l'analyseur de signaux (5) par laquelle un signal de référence (Ref) du générateur de signaux (2) est amené directement à l'analyseur de signaux (5) et l'analyseur de signaux (5) comportant un dispositif de comparaison (13) dans lequel le signal de sortie démodulé (DD) du dispositif sous test (4) est comparé au signal de référence (Ref) afin de déterminer un taux d'erreur sur les bits (BER),
**caractérisé en ce**
**que** l'analyseur de signaux (5) comporte un dispositif de décalage dans le temps (15) qui décale le signal de référence (Ref) ou le signal de sortie démodulé (DD) du dispositif sous test (4) d'un décalage dans le temps (Δt) qui correspond à l'écart temporel (τ) entre le signal de sortie démodulé (DD) du dispositif sous test (4) et le signal de référence (Ref).

2. Système de mesure selon la revendication 1,
**caractérisé en ce**
**qu'**il s'agit quant au signal de référence (Ref) des données de modulation (MD) avec lesquelles le générateur de signaux (2) module le signal de mesure (MS) à haute fréquence.

3. Système de mesure selon la revendication 1,
**caractérisé en ce**
**que** le générateur de signaux (2) comporte un modulateur I/Q (8) et en ce qu'il s'agit quant au signal de référence (Ref) des signaux de sortie en phase et en quadrature (I/Q) du modulateur I/Q (8).

4. Système de mesure selon la revendication 1,
**caractérisé en ce**
**que** le générateur de signaux (2) comporte un modulateur à déplacement (saut) de fréquence (FSK) et en ce qu'il s'agit quant au signal de référence (Ref) de la série des valeurs de fréquence qui sont sautées par le modulateur à déplacement de fréquence (MDF).

5. Système de mesure selon la revendication 1,
**caractérisé en ce**
**que** le signal de référence (Ref) contient une séquence de synchronisation (TS) avec laquelle on peut identifier une section de signal (SLO à SL7) du signal de mesure (MS) à haute fréquence généré par le générateur de signaux (2).

6. Système de mesure selon la revendication 1,
**caractérisé en ce**
**que** l'analyseur de signaux (5) comporte un corrélateur (14) qui effectue une corrélation du signal de sortie démodulé (DD) du dispositif sous test (4) avec le signal de référence (Ref) afin de déterminer l'écart temporel (τ) entre le signal de sortie démodulé (DD) du dispositif sous test (4) et le signal de référence (Ref).
